(19) **Europäisches Patentamt**
**European Patent Office**
**Office européen des brevets**

(11) **EP 4 704 342 A1**

(12) **DEMANDE DE BREVET EUROPEEN**

(43) Date de publication:
04.03.2026 Bulletin 2026/10

(51) Classification Internationale des Brevets (IPC):
*H03H 17/02* (2006.01)       *H03H 17/00* (2006.01)

(21) Numéro de dépôt: 25198248.4

(52) Classification Coopérative des Brevets (CPC):
**H03H 17/0294;** H03H 2017/0081; H03H 2017/0297

(22) Date de dépôt: 26.08.2025

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **27.08.2024 FR 2409146**

(71) Demandeur: **THALES**
**92190 Meudon (FR)**

(72) Inventeur: **AUFFRET, Marie**
**33700 Merignac (FR)**

(74) Mandataire: **Lavoix**
**2, place d'Estienne d'Orves**
**75441 Paris Cedex 09 (FR)**

(54) **PROCÉDÉ DE DÉTERMINATION D'UN FILTRE À RÉPONSE IMPULSIONNELLE FINIE, ET PROGRAMME D'ORDINATEUR ET SYSTÈME DE DÉTERMINATION ASSOCIÉS**

(57)     La présente invention concerne **un procédé de détermination d'un filtre à réponse** impulsionnelle finie, comprenant les étapes suivantes :
- **génération (120) d'une pluralité d'individus présentant des paramètres de configuration ;**
- **mise en œuvre (130) cyclique des sous**-étapes suivantes en relation avec chaque population en cours de paramètres de configuration :
- **évaluation (131) par une fonction d'objectif de chaque individu ;**
- évaluation (132) par au moins une fonction de contrainte de chaque individu ;
- **sélection (133) d'un groupe d'individus parmi l'ensemble des individus en fonction de** leurs évaluations par la **fonction d'objectif et par la fonction de contrainte, et formation** des individus parents ;
- croisement (134) des individus parents pour former une nouvelle population ;
- mutation (135) des individus de la nouvelle population ;
- **vérification (136) d'un critère d'arrêt**

FIG.5

**Description**

La présente invention concerne un procédé de détermination d'un filtre à réponse impulsionnelle finie.

La présente invention concerne également un programme d'ordinateur et un système de détermination associés à ce procédé de détermination.

Le domaine technique de l'invention est celui de traitement de signaux analogiques, par exemple issus de différents capteurs, notamment des capteurs avioniques comme par exemple des capteurs de position.

De manière connue en soi, à partir d'un signal sinusoïdal de référence qui est envoyé à ces capteurs (souvent appelé excitation), les capteurs renvoient un ou plusieurs signaux sinusoïdaux dont l'amplitude est une fonction connue de la position du capteur.

Pour déduire la position du capteur, il est donc nécessaire de mesurer l'amplitude de signaux sinusoïdaux.

La mesure de l'amplitude d'une sinusoïde passe généralement par un premier étage de traitement qui transforme ce signal sinusoïdal en un autre signal qui comprend une partie oscillante superposée à une partie continue. La partie oscillante est un artefact non désiré mais inévitable, et la partie continue est proportionnelle à l'amplitude et contient l'information recherchée.

Un deuxième étage de traitement est chargé d'éliminer la partie oscillante tout en préservant la partie continue. La mesure de la partie continue ainsi isolée est alors très simple, et permet d'accéder à la valeur de l'amplitude.

Pour effectuer un tel traitement, un filtre à réponse impulsionnelle finie (appelé « FIR », de l'anglais «Finite Impulse Response») est généralement utilisé. Ce type de filtre est le plus souvent utilisé pour plusieurs raisons, parmi lesquelles on peut citer son côté déterministe et robuste, en plus de sa capacité de recouvrement suite à une perturbation tout en gardant une latence faible.

Un filtre de type FIR est généralement mis en œuvre par un calculateur embarqué ou au moins est relié à une interface d'un tel calculateur. Le calculateur embarqué est par exemple celui de commande de vol. Ainsi, ce filtre est conçu pour un fonctionnement optimal avec ce calculateur et un type de signaux particulier.

Les calculateurs utilisés à ce jour sont conçus avec des interfaces définies au moment de leur conception. Lorsqu'un nouveau besoin apparait durant le développement ou une modification est nécessaire, l'ensemble de la conception est généralement à revoir.

Afin de réduire la taille des calculateurs tout en offrant plus de flexibilité, des solutions versatiles doivent être mises au point permettant de paramétrer les interfaces grâce à une configuration logicielle. Cette versatilité permet de réduire la quantité d'interface en regroupant les interfaces par nature et en configurant de manière logicielle leurs caractéristiques.

Ainsi, le filtre de type FIR mis en œuvre par ou relié à un calculateur classique ou versatile doit également être modifié pour pouvoir assurer le nouveau besoin.

Or, souvent, une telle modification du filtre ne peut pas se faire de manière automatique et une intervention humaine est généralement nécessaire dans le cas des calculateurs classiques.

En ce qui concerne les calculateurs versatiles, pour être accepté à bord d'un aéronef, un tel calculateur doit apporter la preuve qu'il a été validé sur un grand nombre de configurations. Cette nécessité implique que le filtre de type FIR soit précisément réglé pour chaque configuration supportée, qu'il s'agisse des configurations du calculateur ou des signaux. Avec des besoins de polyvalence si importants (plusieurs centaines de configurations supportées), un réglage manuel du filtre pour respecter les nouvelles configurations n'est plus envisageable.

Ainsi, il existe un besoin d'une plus grande flexibilité des filtres de type FIR pour toute nouvelle configuration et cela sans aucune intervention humaine.

L'invention a donc pour objectif de proposer des moyens permettant d'assurer une grande flexibilité des filtres de type FIR pour toute nouvelle configuration et cela de manière automatique.

À cet effet, l'invention a pour objet un procédé de détermination d'un filtre à réponse impulsionnelle finie comprenant un enchainement de filtres coupe-bandes sinusoïdaux, chaque filtre coupe-bandes sinusoïdal étant déterminé par un jeu de paramètres de configuration, le procédé comprenant les étapes suivantes :

- génération d'une pluralité d'individus présentant des paramètres de configuration, les individus formant une population initiale de paramètres de configuration ;
- mise en œuvre cyclique des sous-étapes suivantes en relation avec chaque population en cours de paramètres de configuration :

   + évaluation par une fonction d'objectif de chaque individu de la population en cours ;
   + évaluation par au moins une fonction de contrainte de chaque individu de la population en cours ;
   + sélection d'un groupe d'individus parmi l'ensemble des individus de la population en cours en fonction de leurs évaluations par la fonction d'objectif et par la fonction de contrainte, et formation des individus parents par des individus issus de ce groupe ;

+ croisement des individus parents pour former une nouvelle population de paramètres de configuration ;
+ mutation des individus de la nouvelle population de paramètres de configuration ;
+ vérification d'un critère d'arrêt.

Suivant d'autres aspects avantageux de l'invention, le procédé comprend une ou plusieurs des caractéristiques suivantes, prises isolément ou suivant toutes les combinaisons techniquement possibles :

- les individus de la population initiale sont générés aléatoirement dans des plages de valeurs prédéterminées ;
- le jeu de paramètres de configuration de chaque filtre coupe-bandes sinusoïdal comprend une fréquence de coupure et un écartement de ce filtre ;
- la fonction d'objectif est déterminée par des paramètres opérationnels comprenant au moins l'un des éléments choisi dans le groupe comprenant :

  - paramètres des signaux à traiter par le filtre à réponse impulsionnelle finie ;
  - paramètres d'équipements matériels traitant des signaux à traiter par le filtre à réponse impulsionnelle finie ;
  - modèle du filtre à réponse impulsionnelle finie ;
  - spécifications du filtre à réponse impulsionnelle finie ;
  - contraintes métier ;

- la fonction d'objectif correspond à la différence du gain du filtre à réponse impulsionnelle finie et une valeur de gain optimal limite prédéterminée ;
- le gain du filtre à réponse impulsionnelle finie est déterminée par le gain de chaque filtre coupe-bandes sinusoïdal et par un gain d'une moyenne glissante ;
- la sous-étape de sélection comprend la sélection des individus ayant plus petites évaluations par la fonction d'objectif que les autres individus ;
- la ou chaque fonction de contrainte est déterminée par des paramètres opérationnelles comprenant au moins l'un des éléments choisi dans le groupe comprenant :

  - paramètres des signaux à traiter par le filtre à réponse impulsionnelle finie ;
  - paramètres d'équipements matériels traitant des signaux à traiter par le filtre à réponse impulsionnelle finie ;
  - modèle du filtre à réponse impulsionnelle finie ;
  - spécifications du filtre à réponse impulsionnelle finie ;
  - contraintes métier ;

- la ou chaque fonction de contrainte vérifie au moins l'une des contraintes choisie dans le groupe comprenant :

  - contrainte de latence ;
  - contrainte de gabarits dans le domaine fréquentiel ;
  - contrainte d'atténuation régulière dans une bande utile ;
  - contrainte sur un gain statique ;
  - contrainte sur une réponse impulsionnelle ;

- la formation des individus parents comprend une sélection aléatoire d'individus dans ledit groupe d'individus ;
- le filtre à réponse impulsionnelle finie comprend en outre une moyenne glissante déterminé par au moins un paramètre de configuration, ledit paramètre de configuration étant inclus dans chaque population en cours de paramètres de configuration.

L'invention concerne également un programme d'ordinateur comportant des instructions logicielles qui, lorsqu'elles sont exécutées par un ordinateur, mettent en œuvre le procédé tel que défini ci-dessus.

L'invention concerne finalement un système de détermination d'un filtre à réponse impulsionnelle finie comprenant un enchainement de filtres coupe-bandes sinusoïdaux, comprenant des moyens techniques configurés pour mettre en œuvre le procédé tel que défini ci-dessus.

L'invention apparaîtra plus clairement à la lecture de la description qui va suivre, donnée uniquement à titre d'exemple non limitatif, et faite en référence aux dessins dans lesquels :

- [Fig.1] la figure 1 est une vue d'une architecture d'acquisition de signaux analogiques comprenant un dispositif de filtrage ;
- [Fig. 2] la figure 2 est une vue détaillée du dispositif de filtrage de la figure 1, le dispositif de filtrage comprenant une unité de filtrage configurée pour mettre en œuvre un filtre à réponse impulsionnelle finie ;

- [Fig. 3] la figure 3 est une vue schématique du filtre à réponse impulsionnelle finie mis en œuvre par l'unité de filtrage de la figure 2 ;
- [Fig. 4] la figure 4 est une vue schématique d'un dispositif de détermination du filtre de la figure 3 ;
- [Fig. 5] la figure 5 est un organigramme d'un procédé de détermination selon l'invention, le procédé étant mis en oeuvre par le dispositif de la figure 4 ; et
- [Fig. 6] [Fig. 7] [Fig. 8] [Fig. 9] les figures 6 à 8 sont différentes illustrations de la mise en œuvre d'au moins certaines des étapes du procédé de la figure 5.

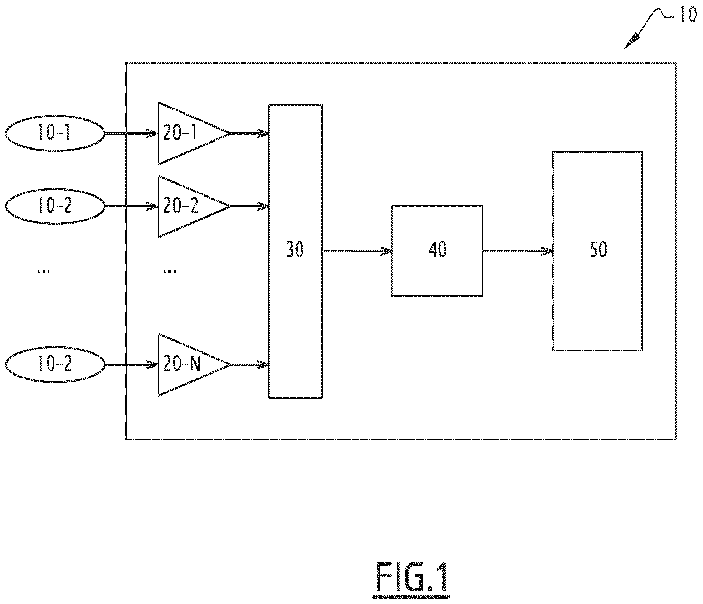

La figure 1 illustre une architecture d'acquisition 10 de signaux analogiques, utilisable par exemple dans le domaine avionique. Cette architecture 10 permet de convertir des signaux analogiques en signaux numériques et de transmettre ces derniers à une ou plusieurs applications avioniques.

Selon d'autres modes de réalisation, l'architecture d'acquisition 10 est utilisable dans tout autre domaine mettant en œuvre une conversion de signaux analogiques en signaux numériques.

En référence à la figure 1, l'architecture d'acquisition 10 comprend un ensemble de capteurs 10-1,...,10-N, un ensemble de conditionneurs de signaux 20-1,...,20-N, un convertisseur analogique-numérique 30, un dispositif de filtrage 40 et un ou plusieurs logiciels 50.

Les capteurs 10-1,...,10-N sont au nombre N (N>0) et sont par exemple des capteurs avioniques de la même nature ou de natures différentes. Chaque capteur 10-1,...,10-N est configuré plus particulièrement pour mesurer au moins une grandeur physique ou pour recevoir des signaux externes, et pour générer, à de cette mesure ou de signaux externes, des signaux analogiques. Ainsi, chaque capteur 10-1,...,10-N correspond par exemple à un capteur de position, de pression, de vitesse, de température, ou par exemple à un capteur de signaux GNSS (de l'anglais « Global Navigation Satellite Systems ») ou de tout autre signal relatif à la position de l'aéronef. Lorsqu'il s'agit d'un capteur de position, celui-ci peut correspondre à un capteur électromagnétique, par exemple un capteur linéaire de type LVDT (de l'anglais « Linear Variable Differential Transformer »), un capteur rotatif de type RVDT (de l'anglais « Rotary Variable Differential Transformer »), un capteur rotatif résolveur ou encore, un capteur rotatif de type SYNCHRO.

Les conditionneurs de signaux 20-1,...,20-N, dont le nombre dépend du nombre de capteurs 10-1,...,10-N, sont connectés à ces derniers et permettent par exemple d'amplifier et/ou de mettre en forme les signaux analogiques acquis par ces capteurs 10-1,...,10-N. Avantageusement, les conditionneurs 20-1,...,20-N sont au nombre N, tout comme les capteurs 10-1,...,10-N. Ainsi, chaque conditionneur 20-1,...,20-N est raccordé à un capteur respectif 10-1,...,10-N.

Le convertisseur analogique-numérique 30 est connecté à l'ensemble des conditionneurs de signaux 20-1,...,20-N et permet de convertir les signaux analogiques issus des conditionneurs 20-1,...,20-N en signaux numériques. Un tel convertisseur 30 est connu par exemple sous l'abréviation « ADC » (de l'anglais « Analog to Digital Converter »).

Le ou chaque logiciel 50 présente par exemple une application avionique connectée au dispositif de filtrage 40. Un tel logiciel 50 est configuré pour recevoir des signaux numériques issus de ce dispositif de filtrage 40 et pour les traiter en fonction de la nature du capteur 10-1,...,10-N correspondant à ces signaux. Par exemple, un tel logiciel 50 est configuré pour déduire la position d'un élément mobile de l'aéronef à partir des signaux acquis sont issus d'un ou plusieurs capteurs de position, pour afficher et/ou communiquer à tout système intéressé cette position et/ou la vitesse de l'aéronef. Le ou chaque logiciel 50 est mis en œuvre par un calculateur embarqué, tel que par exemple un calculateur de commande de vol, connu en soi.

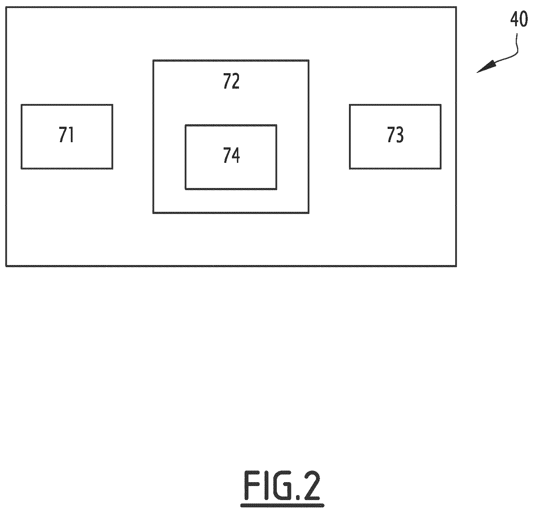

Le dispositif de filtrage 40 est illustré plus en détail sur la figure 2. Ce dispositif de filtrage 40 est par exemple mis en œuvre au moins partiellement, avantageusement entièrement, sous la forme d'un ou de plusieurs circuits logiques programmable tels que FPGA (de l'anglais « Field Programmable Gate Array ») ou d'un µcontroller. En complément ou en variante, ce dispositif de filtrage 40 est mis en œuvre au moins partiellement sous la forme d'un ou de plusieurs logiciels. Dans ce cas, ces logiciels sont stockés dans une mémoire adaptée et sont exécutables par un ou plusieurs processeurs.

En référence à la figure 2, le dispositif de filtrage 40 comprend un module d'entrée 71, un module de traitement 72 et un module de sortie 73.

Le module d'entrée 71 permet de recevoir les signaux numériques convertis par le convertisseur analogique-numérique 30.

Le module de traitement 72 permet de traiter les signaux numériques convertis afin d'éliminer leur partie variable dans le temps. En particulier, pour ce faire, le module de traitement 72 comprend une unité de filtrage passe-bas 74 configurée pour appliquer un filtre coupe-bande sinusoïdal et plus particulièrement, un filtre à réponse impulsionnelle finie, appelé également filtre de type FIR (de l'anglais «Finite Impulse Response»).

Enfin, le module de sortie 73 permet de transmettre les signaux traités par le module de traitement 72 à un ou plusieurs logiciel 50.

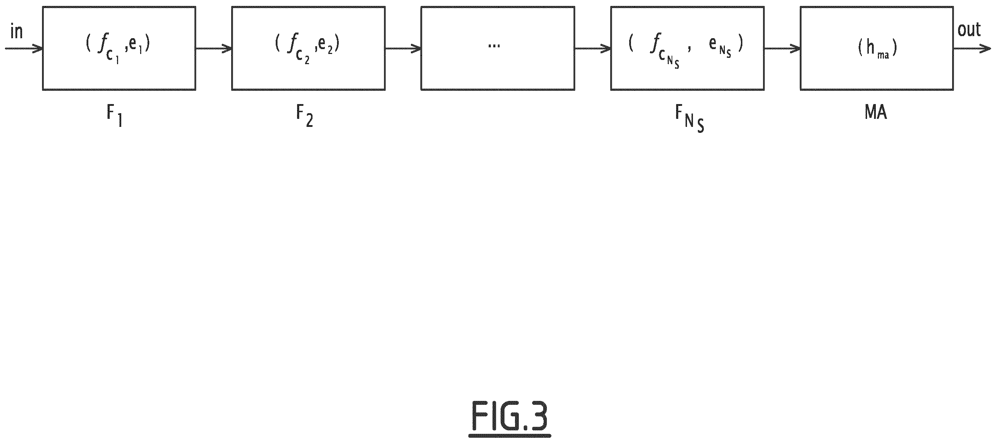

Comme cela est illustré sur cette figure 3, le filtre F de type FIR comprend un enchainement de Ns filtres coupe-bandes sinusoïdaux en série et avantageusement terminé par un filtre à moyenne glissante MA.

Par « enchainement de Ns filtres », on entend une application enchainée de ces filtres de sorte que chaque filtre suivant (sauf le premier filtre) est appliqué à la sortie du filtre précédent. Le premier filtre est appliqué à la fonction initiale. La moyenne glissante est appliquée à la sortie du filtre $F_{Ns}$.

Par « filtre coupe-bandes sinusoïdal » appelé également filtre CBS, on entend un filtre numérique de type FIR dont la courbe du gain en fonction de la fréquence est une fonction sinusoïdale de la fréquence.

Plus particulièrement, le cas d'un filtre coupe-bandes sinusoïdal, sa courbe du gain $H_i(f)$ est une fonction sinusoïdale de la fréquence.

Chaque filtre CBS $F_i$ est déterminé par un jeu de paramètres de configuration.

Ces paramètres de configuration peuvent prendre différentes formes, comme par exemple des fréquences de coupures, des coefficients du filtre, des facteurs d'amortissement, etc.

Avantageusement, dans l'exemple décrit ci-dessous, les paramètres de configuration de chaque filtre CBS $F_i$ comprennent une fréquence de coupure $t_{c_i}$ et un écartement $e_i$ de ce filtre.

La moyenne glissante MA est déterminée également par un jeu de paramètres de configurations comprenant au moins un paramètre de configuration, par exemple son horizon $h_{ma}$.

Ainsi, dans l'exemple décrit ci-dessous, le nombre total $N_p$ de paramètres de configuration du filtre F est égal à $2Ns + 1$.

Par ailleurs, chaque filtre CBS $F_i$ est déterminé par un modèle du filtre déterminant sa fonction de gain $H_i(f)$ et sa réponse impulsionnelle $h_i[n]$.

Ces fonctions $H_i(f)$ et $h_i[n]$ sont par exemple choisies comme suit :

$$H_i(f) = \frac{1}{2 - 2\cos\left(2\pi f_{c_i} e_i T_s\right)} \frac{e^{je_i 2\pi f T_s} - 2\cos\left(2\pi f_{c_i} e_i T_s\right) + e^{-je_i 2\pi f T_s}}{e^{je_i 2\pi f T_s}},$$

$$h_i[n] = \frac{1}{2 - 2\cos\left(2\pi f_{c_i} e_i T_s\right)} \delta[n] - \frac{2\cos\left(2\pi f_{c_i} e_i T_s\right)}{2 - 2\cos\left(2\pi f_{c_i} e_i T_s\right)} \delta[n - e_i] + \frac{1}{2 - 2\cos\left(2\pi f_{c_i} e_i T_s\right)} \delta[n - 2e_i]$$

où :

$T_s$ est la période d'échantillonnage.

Par ailleurs, la fonction de gain $H_{ma}(f)$ pour la moyenne glissante MA est choisie comme suit :

$$H_{ma}(f) = \frac{1}{h_{ma}} \frac{1 - e^{-j2\pi f h_{ma} T_s}}{1 - e^{-j2\pi f T_s}}.$$

Ainsi, le gain $|H(f)|$ du filtre F dans le domaine fréquentiel est exprimé comme suit :

$$|H(f)| = |H_{ma(f)}| \left(\prod_{i=1}^{Ns} |H_i(f)|\right) =$$

$$= \left|\frac{1}{h_{ma}} \frac{1 - e^{-j2\pi f h_{ma} T_s}}{1 - e^{-j2\pi f T_s}}\right| \left(\prod_{i=1}^{Ns} \left|\frac{\cos(2\pi f e_i T_s) - \cos(2\pi f_{c_i} e_i T_s)}{1 - \cos(2\pi f_{c_i} e_i T_s)}\right|\right).$$

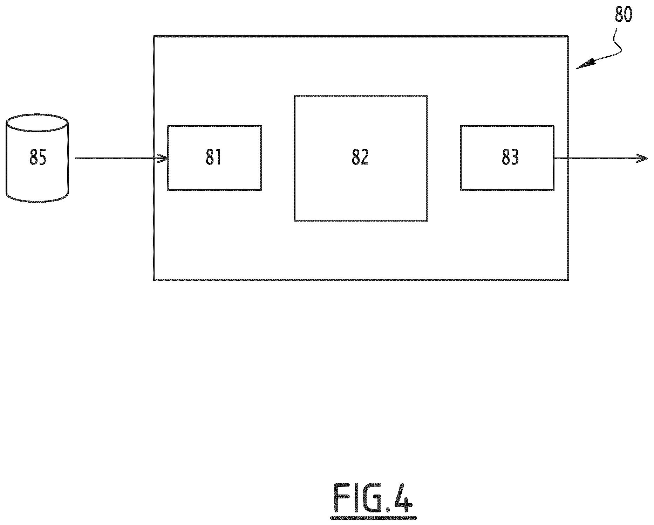

La figure 4 illustre un dispositif de détermination 80 permettant de déterminer le filtre F de type FIR, tel qu'illustré sur la figure 3. En particulier, le dispositif de détermination 80 permet de déterminer les paramètres de configuration de chaque filtre CBS et de la moyenne glissante MA, comme cela sera expliqué plus en détail par la suite.

Le dispositif de détermination 80 est par exemple mis en œuvre au moins partiellement sous la forme d'un ou de plusieurs circuits logiques programmable tels que FPGA (de l'anglais « Field Programmable Gate Array »). En complément ou en variante, ce dispositif de détermination 80 est mis en œuvre au moins partiellement sous la forme d'un ou de plusieurs logiciels. Dans ce cas, ces logiciels sont stockés dans une mémoire adaptée et sont exécutables par un ou plusieurs processeurs.

En référence à la figure 4, le dispositif de détermination 80 comprend un module d'entrée 81, un module de traitement 82 et un module de sortie 83.

Le module d'entrée 81 permet de recevoir des paramètres opérationnels permettant d'adapter le filtre F de type FIR à son environnement de fonctionnement. Ces paramètres opérationnels sont par exemple issus d'une base de données 85 et comprennent au moins l'un des éléments choisi dans le groupe comprenant :

- paramètres des signaux à traiter par le filtre à réponse impulsionnelle finie ;
- paramètres d'équipements matériels traitant des signaux à traiter par le filtre à réponse impulsionnelle finie ;
- modèle du filtre à réponse impulsionnelle finie ;
- spécifications du filtre à réponse impulsionnelle finie ;
- contraintes métier.

Les paramètres des signaux à traiter comprennent par exemple une fréquence d'excitation $f_{ex}$, une fréquence d'harmonique $f_h$ et un niveau de bruit $G_s(f)$ de ces signaux. Ces paramètres sont par exemple déterminés en fonction de la nature des capteurs 10-1, ..., 10-N et de la nature des signaux générés par ces capteurs.

Les paramètres d'équipements matériels comprennent notamment des paramètres des conditionneurs 20-1, ..., 20-N, du convertisseur analogique-numérique 30 et/ou du calculateur mettant en œuvre le ou chaque logiciel 50. Ces paramètres comprennent par exemple la période d'échantillonnage $T_s$ et/ou la manière de quantification $G_{in}(f)$ du convertisseur analogique-numérique 30.

Le modèle du filtre comprend une définition des fonctions de gain $H_i(f)$ et de réponse impulsionnelle $h_i[n]$ telles que définies précédemment.

Les spécifications du filtre comprennent notamment une bande passante $G_{min}(f)$, une latence maximale $\delta_{max}$, une qualité de filtrage minimale requise en haute-fréquence $G_{max}(f)$, etc.

Les contraintes métier sont par exemple relatives au domaine de l'utilisation du filtre F et notamment des capteurs 10-1, ..., 10-N. Pour le domaine aéronautique, il peut par exemple s'agir d'une réponse impulsionnelle quasi-gaussienne, d'une réponse impulsionnelle régulière, d'une réponse fréquentielle régulière dans la bande passante du signal, etc.

Le module de traitement 82 permet de traiter l'ensemble des paramètres opérationnels pour déterminer les paramètres de configuration, en mettant en œuvre au moins certaines des étapes d'un procédé de détermination qui sera expliqué en détail par la suite.

Enfin, le module de sortie 83 permet de transmettre le filtre F de type FIR et notamment les paramètres de configuration de ce filtre à tout système intéressé et notamment au module de traitement 72 du dispositif de filtrage 40 mettant en œuvre le filtrage des signaux numériques convertis par le convertisseur analogique-numérique 30.

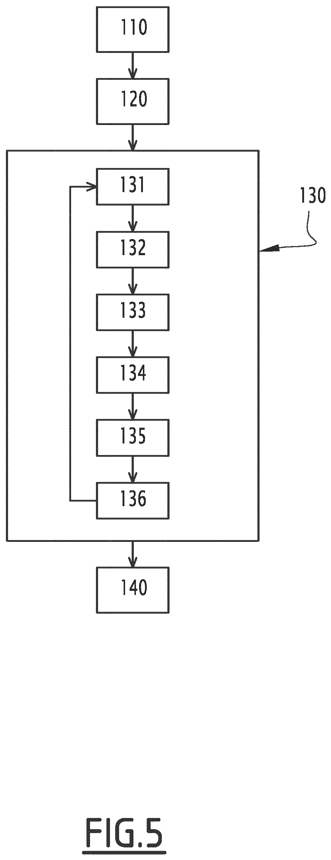

Le procédé de détermination mis en œuvre par le dispositif de détermination 80 sera désormais expliqué en référence à la figure 5 illustrant un organigramme de ses étapes.

Lors d'une étape initiale 110, le module d'entrée 81 reçoit les paramètres opérationnels tels que définis ci-dessus ou une mise à jour de ces paramètres. Cela peut par exemple se faire à la demande du dispositif de filtrage 40 à la suite d'un changement de configuration intervenu dans son environnement.

Puis, le module d'entrée 81 transmet les paramètres opérationnels reçus au module de traitement 82.

Puis, le module de traitement 82 met en œuvre un algorithme génétique lors des étapes suivantes permettant de déterminer les paramètres de configuration du filtre F.

En particulier, lors de l'étape 120, le module de traitement 82 génère une pluralité d'individus présentant des paramètres de configuration. Ces individus forment alors une population initiale.

Par exemple, chaque individu présente les jeux de paramètres de configuration de l'ensemble des filtres CBS $F_i$ et de la moyenne glissante MA.

Avantageusement, chaque individu est choisi de manière aléatoire dans une plage de valeurs prédéterminée. Cette plage de valeurs peut par exemple être prédéterminée en fonction d'au moins certains paramètres opérationnels.

Alternativement, en cas d'une mise à jour du filtre F, chaque individu correspond aux jeux de paramètres de configuration de l'ensemble des filtres CBS $F_i$ et de la moyenne glissante MA, déterminé précédemment.

Lors de l'étape suivante 130, le module de traitement 82 met en œuvre de manière cyclique des sous-étapes 131 à 136 en relation avec chaque population en cours de paramètres de configuration. Initialement, la population en cours correspond à la population initiale déterminée lors de l'étape 120.

Lors de la sous-étape 131, le module de traitement évalue une fonction d'objectif de chaque individu de la population en cours.

En particulier, la fonction d'objectif permet d'associer à chaque individu une valeur, appelée également score, permettant de caractériser la capacité de cet individu à la survie.

Avantageusement, en relation avec un même individu, la fonction d'objectif n'est calculée qu'une seule fois lorsque cet individu passe à la génération suivante.

Selon l'invention, le problème d'optimisation déterminant le choix de la fonction d'objectif est ramené à un problème d'aire entre le courbe du gain du filtre F dans le domaine fréquentiel et une valeur de gain optimal limite correspondant au niveau de bruit $G_s(f)$ des signaux à traiter, pour une bande de fréquences $[a_1, b_1]$. L'objectif du problème d'optimisation est alors de minimiser cette aire.

Ce choix a été arbitré suivant le souhait de privilégier un filtre qui est globalement proche de la courbe de gain optimal limite afin d'avoir une bonne performance par rapport au bruit. L'aire est une bonne manière de pondérer cette optimisation globale pour rejeter le bruit présent sur tout le spectre.

Chercher à atténuer des hautes fréquences au-delà de la valeur de gain optimal limite n'apporte pas plus d'intérêt supplémentaire parce que les perturbations à éliminer ne sont pas de cet ordre-là. On définit ainsi la valeur de gain optimal limite comme celle qui élimine toutes les perturbations plausibles.

Conformément, la fonction d'objectif utilisée est $f_1(x)$ :

$$f_1(x) = \int_{a_1}^{b_1} (|H^*(f)| - G_s(f)) \, df$$

où :

$$|H^*(f)| = \begin{cases} |H(f)|, & |H(f)| \geq G_s(f) \\ G_s(f), & |H(f)| < G_s(f) \end{cases}$$

La fonction $|H(f)|$ correspond alors au gain du filtre F tel que défini précédemment.

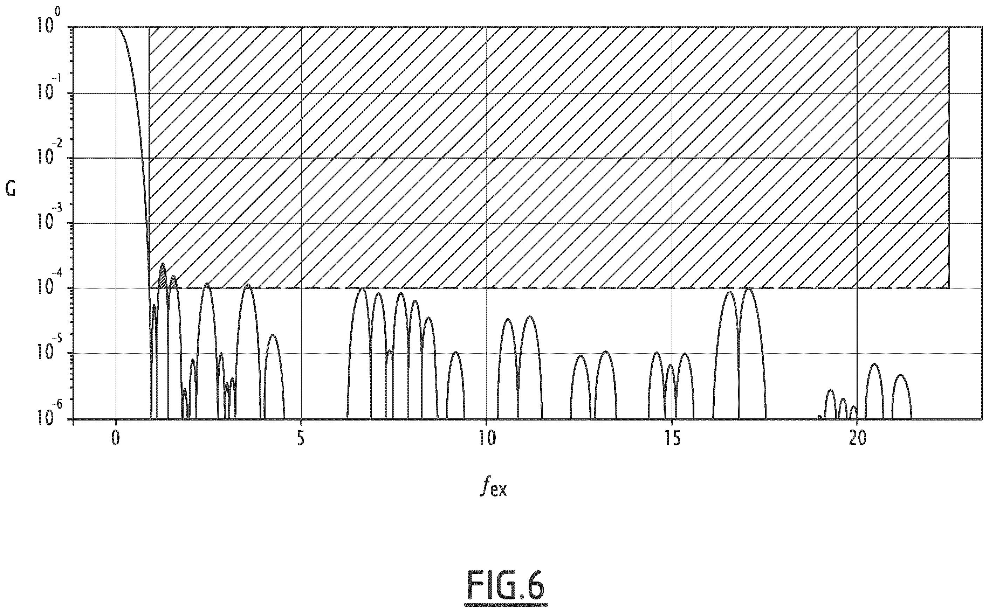

La figure 6 illustre la réponse fréquentielle G aux différentes fréquences d'excitation $f_{ex}$ du filtre F de type FIR qui est représentée par un trait plein noir. Ici, la cible de gain optimal limite, représentée par un trait pointillé noir, est une constante $G_s(f) = 10^{-4}$ sur la bande de fréquence $[f_{ex}, f_{max}]$. La région hachurée délimite l'espace où l'algorithme d'optimisation s'efforce de maintenir la courbe de gain en deçà. La fonction d'objectif représente l'évaluation de l'aire hachurée dense.

Lors de la sous-étape 132, le module de traitement 82 évalue chaque individu de la population en cours par au moins une fonction de contrainte, avantageusement par plusieurs fonctions de contrainte.

En particulier, lors de cette étape, plusieurs fonctions de contrainte sont appliquées afin de labéliser les individus (i.e. jeux de paramètres de configuration) pour distinguer les individus qui respectent la spécification du filtre de ceux qui ne la respecte pas.

Par exemple, un individu qui respecte l'ensemble des fonctions de contrainte est labélisé comme « solution faisable ». Un individu qui ne respecte pas au moins une fonction de contrainte est labélisé comme « solution infaisable ».

Les fonctions de contrainte sont par exemple rédigées sous forme d'inégalité. Une fonction de contrainte n'est pas respectée si son évaluation sur l'individu correspondant donne un résultat strictement positif. Autrement, cette fonction de contrainte est respectée.

Avantageusement, selon l'invention, une fonction de contrainte peut être ajoutée ou éliminée en fonction de la spécification du filtre F à obtenir.

En outre, avantageusement, chaque fonction de contrainte est déterminée au moins partiellement en fonction des paramètres opérationnels.

Ci-dessous, sont donnés quelques exemples de fonctions de contrainte.

En particulier, selon cet exemple, la ou chaque fonction de contrainte vérifie l'une des contraintes choisie dans le groupe comprenant :

- contrainte de latence ;
- contrainte de gabarits dans le domaine fréquentiel ;
- contrainte d'atténuation régulière dans une bande utile ;
- contrainte sur un gain statique ;
- contrainte sur une réponse impulsionnelle.

La contrainte de latence peut s'exprimer sous différentes formes suivant la spécification du filtre F. Par exemple, sous la forme d'un retard intrinsèque au filtre (i.e. l'abscisse du centre de gravité de la fonction de poids) ou bien sous la forme d'un retard de la réponse temporelle du filtre par rapport à une rampe. D'autres expressions de la latence peuvent être facilement incorporées sous forme de contraintes dans l'algorithme. Deux exemples sont détaillés ci-après à titre illustratif.

Un premier exemple concerne une contrainte sur le retard intrinsèque du filtre.

Selon cet exemple, le retard intrinsèque du filtre ne doit pas dépasser la latence maximale autorisée du filtre $\delta_{max}$. Par conséquent, tous les filtres qui ont un retard strictement supérieur à $\delta_{max}$ sont rejetés. La contrainte peut être définie comme suit :

$$g_1(x) = T_s\left(\frac{h_{ma}}{2} + \sum_{i=1}^{N} e_i - 0.5\right) - \delta_{max} \leq 0.$$

Un deuxième exemple concerne une contrainte sur le retard de la réponse temporelle du filtre a une rampe.

Selon cet exemple, le retard de la réponse temporelle du filtre à une rampe ne doit pas dépasser la latence maximale autorisée du filtre $\delta_{max}$. Le filtre étant échantillonné à une période $T_s$, le retard est mesuré comme étant la différence entre l'échantillon du point milieu de l'excitation $n_{exc}$ et l'échantillon du point milieu de la réponse temporelle $n_{rep}$.

L'excursion de la rampe est prise entre 0 V et 10 V (ces valeurs sont configurables suivant la spécification du filtre). Comme le filtre a un gain unitaire, la rampe de la réponse temporelle a la même plage d'excursion que l'excitation. Ainsi, la valeur de la tension à mi excursion est 5V et l'échantillon le plus proche de cette valeur est noté $n_{rep}$.

Par conséquent, tous les filtres qui ont un retard strictement supérieur à $\delta_{max}$ sont rejetés. La contrainte peut être définie comme suit :

$$g_2(x) = T_s\big(n_{rep} - n_{exc}\big) - \delta_{max} \leq 0.$$

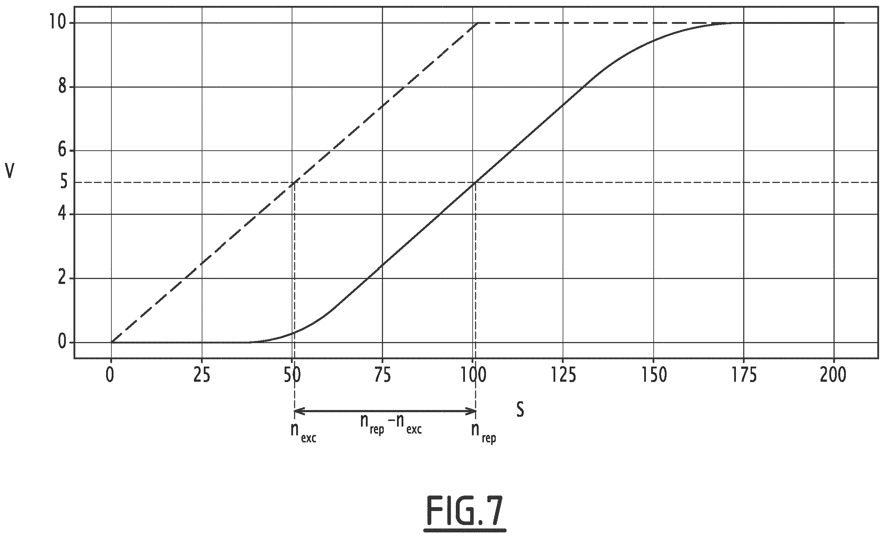

L'application de cette contrainte est illustrée sur le graphique de la figure 7 sur laquelle l'axe S désigne le nombre d'échantillons et l'axe V désigne l'amplitude (en volt) des signaux. Sur ce graphique, la courbe en trait interrompu correspond à l'amplitude de la rampe d'excitation et la courbe en trait continu correspond à l'amplitude de la réponse du filtre à la rampe d'excitation. Par ailleurs, les points sur le graphique correspondent aux échantillons du point milieu de l'excitation $n_{exc}$ et aux échantillons du point milieu de la réponse temporelle $n_{rep}$.

La contrainte de gabarits dans le domaine fréquentiel permet d'inclure une ou plusieurs contraintes de façon à ce que la courbe de gain du filtre se situe entièrement en-dessous d'une courbe (notée $G_1(f)$ par exemple) dans le domaine fréquentiel. Cette contrainte se rédige comme suit sur la bande de fréquence $[f_1, f_2]$ :

$$g_3(x) = |H_i(f)| - G_1(f) \leq 0, \qquad \forall f \in [f_1, f_2]$$

Cela permet de définir une bande de fréquences à éliminer.

Il est également possible d'inclure une ou plusieurs contraintes **de** façon **à ce que** la courbe de gain du filtre se situe entièrement au-dessus **d'une courbe (notée** $G_2(f)$ par exemple) dans le domaine fréquentiel. Cette contrainte se rédige comme suit sur la bande de fréquence $[f_3, f_4]$ :

$$g_4(x) = G_2(f) - |H_i(f)| \leq 0, \ \forall f \in [f_3, f_4]$$

Cela permet de définir une bande de fréquences à préserver.

Ainsi, en combinant des contraintes du type $g_3$ et/ou du type $g_4$, tous les gabarits peuvent être représentés dans l'algorithme d'exploration de solutions. Il est ainsi aisé de contraindre l'exploration des filtres solutions en fonction du besoin spécifié (ex : largeur de bande-passante, coupures franches sur certaines parties du spectre en fonction de perturbations à rejeter, élimination d'harmoniques...).

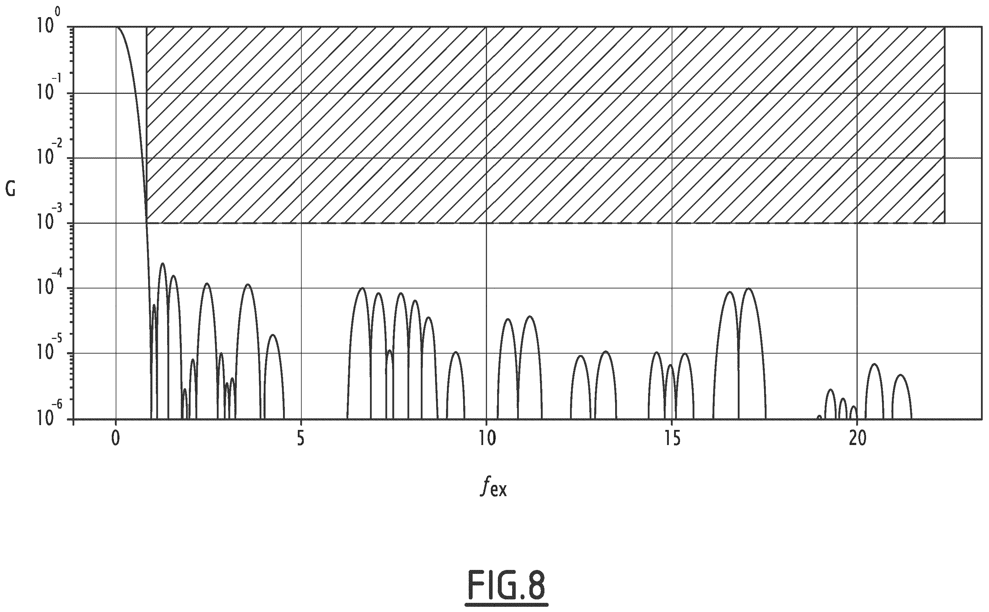

La figure 8 illustre une représentation graphique de la fonction de contrainte du type $g_3$. Sur cette figure, la réponse fréquentielle G du filtre F est représentée par un trait plein noir. La courbe de gain limite à ne pas dépasser est représentée par un trait pointillé noir. Ici, dans cette version simplifiée à titre illustratif, $G_1$ est une constante c'est-à-dire $G_1(f) = 10^{-3}$ sur la bande de fréquence $[f_{ex}, f_{max}]$. La région hachurée délimite l'espace où l'algorithme d'optimisation impose de maintenir la courbe de gain en deçà.

La contrainte d'atténuation régulière dans une bande utile permet d'éviter des singularités dans la partie basse fréquence du spectre. En particulier, une singularité du filtre signifie que certains stimuli d'entrée (i.e. mouvements du capteur ou perturbations du signal) vont donner des résultats très différents des stimuli voisins. Or, il est généralement souhaitable d'éviter de telles singularités, notamment dans le domaine aéronautique.

Le filtre nécessite également d'être contraint dans la bande utile de façon à ce qu'il ait une atténuation régulière. Dans le cas de l'utilisation du filtre F, les basses fréquences correspondent à la bande de fréquence des mouvements du capteur. Dans cette zone, la courbe de gain doit être parfaitement maîtrisée et régulière. Sachant qu'elle doit être décroissante, une contrainte de monotonie s'exprime comme suit :

$$g_5(x) = [|H(f + df)| - |H(f)|] \leq 0, \quad \forall f \in [0, f_{max}]$$

où $df$ désigne un pas à ajuster en fonction de la précision requise.

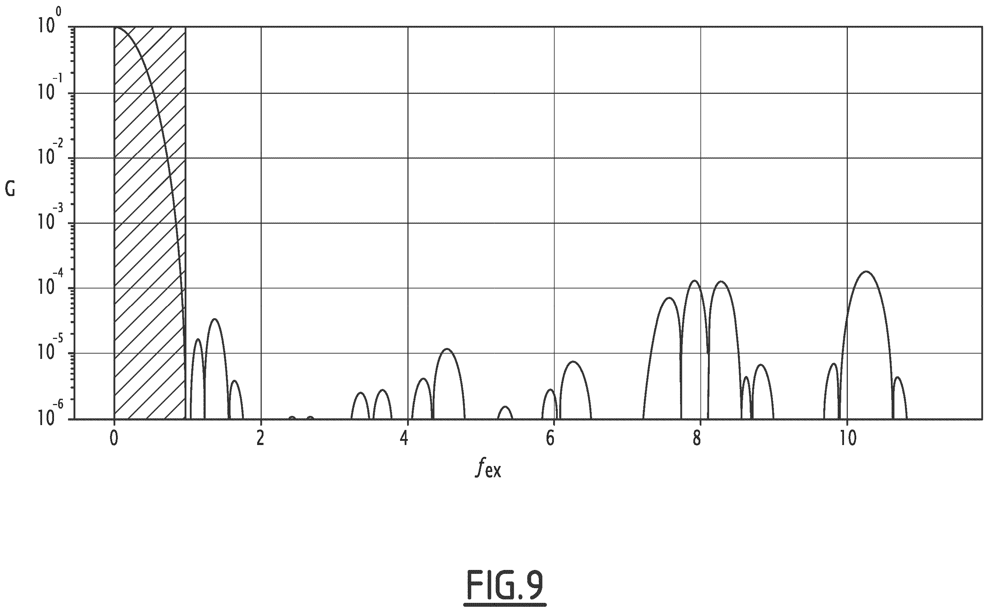

La figure 9 illustre une représentation graphique de la fonction de contrainte du type $g_5$. Sur cette représentation, la zone hachurée représente la zone dans laquelle la réponse fréquentielle doit être strictement décroissante.

La contrainte sur un gain statique d'un filtre CBS $F_i$ s'exprime comme suit :

$$|H_{0_i}(f)| = \frac{1}{2 - 2\cos(2\pi f_{c_i} e_i T_s)}, \quad \forall i \in [1, \dots, N].$$

**Pour** éviter que le gain du filtre explose si l'un des filtres $F_i$ a le dénominateur de son gain statique proche de 0, il est nécessaire de restreindre la valeur des gains statiques pour chacun des étages. Ainsi, chacun des gains statiques doit être en dessous d'une certaine valeur $G_{0_{max}}$.

La contrainte peut être implémentée comme suit :

$$g_6(x) = \sum_{i=1}^{N} \delta_i \leq 0, \quad \text{où } \delta_i = \begin{cases} 1, & \text{si } |H_{0_i}(f)| \geq G_{0_{max}} \\ 0, & \text{sinon} \end{cases}$$

La contrainte sur une réponse impulsionnelle s'explique par le fait que le filtre F doit avoir une réponse impulsionnelle de forme particulière, par exemple de forme Gaussienne, pour atteindre les objectifs de performance.

Or, suivant le réglage de la chaine, l'association des différents filtres CBS ne conduit pas automatiquement à une réponse impulsionnelle quasi gaussienne. De plus, l'association de filtres sinusoïdaux peut éventuellement créer ces singularités.

D'où la présence dans le sous-étape d'une contrainte de monotonie de la réponse impulsionnelle. La combinaison de cette contrainte avec celle de proximité avec une Gaussienne normalement distribuée, permet d'éviter toutes les singularités plausibles.

La contrainte de monotonie de la réponse impulsionnelle permet de parvenir à l'objectif que la première moitié de la réponse impulsionnelle soit strictement croissante et que la seconde moitié soit strictement décroissante.

Cette contrainte s'exprime comme suit :

$$g_7(x) = \begin{cases} [h[n] - h[n+1]] \leq 0, & \forall n \in \left[0, \left\lfloor \frac{n_{ir} - 1}{2} \right\rfloor\right] \\ [h[n+1] - h[n]] \leq 0, & \forall n \in \left[\left\lfloor \frac{n_{ir} - 1}{2} \right\rfloor, n_{ir} - 1\right] \end{cases}$$

où $n_{ir}$ représente le nombre de points de la réponse impulsionnelle.

La contrainte $g_7$, telle qu'elle est exprimée, compte le nombre de points qui ne respectent pas la monotonie. Si la monotonie est respectée, $g_7(x) = 0$ et le filtre solution est accepté (i.e. étiqueté comme faisable). Sinon, $g_7(x) \geq 1$ et le filtre solution est étiqueté comme infaisable.

La contrainte de proximité à une courbe souhaitée (par exemple Gaussienne) s'exprime comme suit :

$$g_8(x) = R^2_{min} - (r_{h\hat{h}})^2 \leq 0$$

où

- $R^2_{min}$ correspond à la plus petite valeur acceptable d'un coefficient de variation $R^2$, variant entre 0 et 1, et correspondant à une mesure statistique de la précision avec laquelle les prédictions de régression approximent les valeurs observées. $R^2 = 1$ indique que la prédiction suit parfaitement la réalité (autrement dit que les données observées correspondent aux données mesurées).

- $r_{xy}$ correspond à un coefficient de corrélation de Pearson (PCC) au carré. Le PCC mesure la corrélation linéaire entre deux sets de données. Il représente le ratio entre la covariance de deux variables et le produit de leur écart-type. Autrement dit, il s'agit d'une mesure normalisée de la covariance. Le PCC peut être exprimé comme suit :

$$r_{xy} = \frac{\sum_{i=1}^{n}(x_i - \bar{x})(y_i - \bar{y})}{\sqrt{\sum_{i=1}^{n}(x_i - \bar{x})^2}\sqrt{\sum_{i=1}^{n}(y_i - \bar{y})^2}}$$

où n est la taille des échantillons.

- h et $\hat{h}$ définissent un modèle gaussien ajusté à la réponse impulsionnelle comme suit :

$$\hat{h}[n] = a \exp\left(-\frac{(n-\mu)^2}{2\sigma^2}\right)$$

où

$$a = \max(h), \ \mu = \frac{E(nh)}{E(h)} \text{ et } \sigma = \frac{1}{a\sqrt{2\pi}}.$$

Lors de la sous-étape 133, le module de traitement 82 sélectionne un groupe d'individus parmi l'ensemble des individus de la population en cours en fonction de leurs évaluations par la fonction d'objectif et par chaque fonction de contrainte.

En particulier, des individus ayant les deux types de label (i.e. « solution faisable » et « solution infaisable ») peuvent être sélectionnés. Selon l'itération en cours de la sous-étape, la part des individus sélectionnés labélisés comme « solution infaisable » peut diminuer progressivement jusqu'à atteindre 0. Ainsi, lors des dernières itérations, seuls individus labélisés comme « solution faisable » peuvent être sélectionnés. Cela peut être nécessaire car lors des premières générations, la part d'individus infaisables dans la population est encore très élevée.

Puis, les individus sont classés selon un ordre croissant des valeurs des fonctions d'objectif correspondantes et M premiers individus sont retenus. Le nombre M est par exemple un paramètre du procédé. Autrement dit, lors des cette sous-étape, seuls les individus ayant les plus petites valeurs de la fonction d'objectif (i.e. les plus petits scores et donc les individus les plus adaptés) sont choisis.

Puis, parmi l'ensemble des individus retenus, le module de traitement 82 choisit un sous-ensemble devant former des individus parents. Cet sous-ensemble est choisi par exemple de manière aléatoire.

Lors de la sous-étape 134, le module de traitement 82 applique un opérateur de croisement aux individus parents pour générer un ou plusieurs enfants.

Cet opérateur de croisement peut prendre différentes formes. Il est par exemple possible de choisir l'opérateur connu sous le nom anglais de « Simulated Binary Crossover » (SBX).

Lors de la sous-étape 135, le module de traitement 82 applique un opérateur de mutation à chaque enfant créé lors de la sous-étape précédente.

Cet opérateur de mutation peut également prendre différentes formes. Il est par exemple possible de choisir un opérateur de distribution polynomiale (« Polynomial Mutation » en anglais).

Lors de la sous-étape 136, le module de traitement 82 vérifie un critère d'arrêt et lorsque celui-ci est rempli, arrête l'exécution de l'étape 130.

Le critère d'arrêt est variable en fonction de la complexité de l'algorithme à converger afin de garantir des résultats de qualité.

Un exemple de condition d'arrêt peut être au bout d'un certain nombre de générations ou bien en fonction de la valeur de la fonction objectif. Par exemple, lorsque le gain $|H(f)|$ du filtre F se trouve entièrement au-dessous du seuil $G_s(f)$, le critère d'arrêt est rempli.

Avantageusement, le critère d'arrêt ne peut être rempli que sur une solution labélisée comme faisable.

Lors de l'étape suivante 140, le module de sortie 83 transmet le filtre déterminé et notamment les paramètres de configuration de ce filtre à tout système intéressé, comme par exemple le module de traitement 72 du dispositif de filtrage 40. Le dispositif de filtrage 40 peut ainsi mettre en œuvre un filtrage des signaux provenant des capteurs 10-1, ..., 10-N.

On conçoit alors que la présente invention présente un certain nombre d'avantages.

Tout d'abord, le procédé selon l'invention permet de déterminer un filtre de type FIR de manière automatique et de l'adapter à tout changement de l'environnement dans lequel ce filtre opère.

Ainsi, le filtre peut être utilisé par des calculateurs versatiles et peut être facilement adapté à tout changement pouvant intervenir dans un tel calculateur.

Selon différents exemples d'application de l'invention, le filtre obtenu par le procédé de détermination selon l'invention respecte les critères suivants, conformément à la spécification du filtre pour chacune des configurations possibles :

- excellente performance du filtrage grâce à un filtrage quasi gaussien assuré par un respect des gabarits de la courbe de gain dans le domaine fréquentiel et de la réponse impulsionnelle du filtre ;
- faible latence vis-à-vis du retard intrinsèque du filtre et du retard de la réponse temporelle à une rampe ;
- grande robustesse par rapport aux perturbations du signal du capteur (bruit, harmoniques, diaphonie...) ;
- grande robustesse vis-à-vis d'une incertitude sur la fréquence principale du capteur ;
- grande robustesse vis-à-vis de la quantification des coefficients sur le calculateur ;
- stabilité du filtre en cascade garantie grâce à une limitation de la valeur du gain statique de chacun des étages.

Bien entendu, de nombreux autres exemples de réalisation de l'invention sont également possibles.

**Revendications**

1. Procédé de détermination d'un filtre à réponse impulsionnelle finie comprenant un enchainement de filtres coupe-bandes sinusoïdaux, chaque filtre coupe-bandes sinusoïdal étant déterminé par un jeu de paramètres de configuration, le procédé comprenant les étapes suivantes :

   - génération (120) d'une pluralité d'individus présentant des paramètres de configuration, les individus formant une population initiale de paramètres de configuration ;
   - mise en œuvre (130) cyclique des sous-étapes suivantes en relation avec chaque population en cours de paramètres de configuration :

      + évaluation (131) par une fonction d'objectif de chaque individu de la population en cours ;
      + évaluation (132) par au moins une fonction de contrainte de chaque individu de la population en cours ;
      + sélection (133) d'un groupe d'individus parmi l'ensemble des individus de la population en cours en fonction de leurs évaluations par la fonction d'objectif et par la fonction de contrainte, et formation des individus parents par des individus issus de ce groupe ;
      + croisement (134) des individus parents pour former une nouvelle population de paramètres de configuration ;
      + mutation (135) des individus de la nouvelle population de paramètres de configuration ;
      + vérification (136) d'un critère d'arrêt.

2. Procédé selon la revendication 1, dans lequel les individus de la population initiale sont générés aléatoirement dans des plages de valeurs prédéterminées.

3. Procédé selon la revendication 1 ou 2, dans lequel le jeu de paramètres de configuration de chaque filtre coupe-bandes sinusoïdal comprend une fréquence de coupure et un écartement de ce filtre.

4. Procédé selon l'une quelconque des revendications précédentes, dans lequel la fonction d'objectif est déterminée par des paramètres opérationnels comprenant au moins l'un des éléments choisi dans le groupe comprenant :

   - paramètres des signaux à traiter par le filtre à réponse impulsionnelle finie ;
   - paramètres d'équipements matériels traitant des signaux à traiter par le filtre à réponse impulsionnelle finie ;
   - modèle du filtre à réponse impulsionnelle finie ;
   - spécifications du filtre à réponse impulsionnelle finie ;
   - contraintes métier.

5. Procédé selon l'une quelconque des revendications précédentes, dans lequel la fonction d'objectif correspond à la différence du gain du filtre à réponse impulsionnelle finie et une valeur de gain optimal limite prédéterminée.

6. Procédé selon la revendication 5, dans lequel le gain du filtre à réponse impulsionnelle finie est déterminée par le gain de chaque filtre coupe-bandes sinusoïdal et par un gain d'une moyenne glissante.

7. Procédé selon la revendication 5 ou 6, dans lequel la sous-étape de sélection (133) comprend la sélection des individus ayant plus petites évaluations par la fonction d'objectif que les autres individus.

8. Procédé selon l'une quelconque des revendications précédentes, dans lequel la ou chaque fonction de contrainte est déterminée par des paramètres opérationnelles comprenant au moins l'un des éléments choisi dans le groupe comprenant :

- paramètres des signaux à traiter par le filtre à réponse impulsionnelle finie ;
- paramètres d'équipements matériels traitant des signaux à traiter par le filtre à réponse impulsionnelle finie ;
- modèle du filtre à réponse impulsionnelle finie ;
- spécifications du filtre à réponse impulsionnelle finie ;
- contraintes métier.

9. Procédé selon l'une quelconque des revendications précédentes, dans lequel la ou chaque fonction de contrainte vérifie au moins l'une des contraintes choisie dans le groupe comprenant :

- contrainte de latence ;
- contrainte de gabarits dans le domaine fréquentiel ;
- contrainte d'atténuation régulière dans une bande utile ;
- contrainte sur un gain statique ;
- contrainte sur une réponse impulsionnelle.

10. Procédé selon l'une quelconque des revendications précédentes, dans lequel la formation des individus parents comprend une sélection aléatoire d'individus dans ledit groupe d'individus.

11. Procédé selon l'une quelconque des revendications précédentes, dans lequel le filtre à réponse impulsionnelle finie comprend en outre une moyenne glissante déterminé par au moins un paramètre de configuration, ledit paramètre de configuration étant inclus dans chaque population en cours de paramètres de configuration.

12. Programme d'ordinateur comportant des instructions logicielles qui, lorsqu'elles sont exécutées par un ordinateur, mettent en œuvre un procédé selon l'une quelconque des revendications précédentes.

13. Système de détermination (80) d'un filtre à réponse impulsionnelle finie comprenant un enchainement de filtres coupe-bandes sinusoïdaux, comprenant des moyens techniques (81, 82, 83) configurés pour mettre en oeuvre le procédé selon l'une quelconque des revendications précédentes.

**FIG.1**

FIG.2

EP 4 704 342 A1

FIG.3

FIG.4

FIG.5

FIG.6

EP 4 704 342 A1

FIG.7

EP 4 704 342 A1

FIG.8

EP 4 704 342 A1

FIG.9

Europäisches
Patentamt

European
Patent Office

Office européen
des brevets

## RAPPORT DE RECHERCHE EUROPEENNE

Numéro de la demande

EP 25 19 8248

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | MOHAMMED S ET AL: "Hardware based genetic evolution of self-adaptive arbitrary response FIR filters", APPLIED SOFT COMPUTING, ELSEVIER, AMSTERDAM, NL, vol. 11, no. 1, 31 janvier 2011 (2011-01-31), pages 842-854, XP027260613, ISSN: 1568-4946 [extrait le 2010-02-01] * page 844, colonne 2 - page 845, colonne 2 * * page 846, colonne 1 * * page 843, colonne 2 - page 846, colonne 1; figure 2 * * page 848, colonne 1 * | 1,3-13 | INV. H03H17/02 H03H17/00 |
| Y | US 2015/236669 A1 (MEHRNIA ALIREZA [US] ET AL) 20 août 2015 (2015-08-20) * figures 1, 2 * | 1-13 | |
| Y | BOSE T ET AL: "Genetic Algorithm-Assisted Design of Adaptive Predictive Filters for 50/60 Hz Power Systems Instrumentation", IEEE TRANSACTIONS ON INSTRUMENTATION AND MEASUREMENT, IEEE, USA, vol. 54, no. 5, 31 octobre 2005 (2005-10-31), pages 2041-2048, XP011140116, ISSN: 0018-9456, DOI: 10.1109/TIM.2005.853230 * Equation 5; page 2043, colonne 2 - page 2044, colonne 1 * | 1-9, 11-13 | **DOMAINES TECHNIQUES RECHERCHES (IPC)** H03H |

-/--

Le présent rapport a été établi pour toutes les revendications

| Lieu de la recherche | Date d'achèvement de la recherche | Examinateur |
|---|---|---|
| Munich | 7 janvier 2026 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.......................................................................................
& : membre de la même famille, document correspondant

EPO FORM 1503 03.82 (P04C02)

page 1 de 2

Europäisches
Patentamt

European
Patent Office

Office européen
des brevets

## RAPPORT DE RECHERCHE EUROPEENNE

**Numéro de la demande**

**EP 25 19 8248**

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | Long Guo: "Subband Adaptive Filtering for Active Broadband Noise Control with Application to Road Noise Inside Vehicles", , 22 juin 2020 (2020-06-22), XP093209300, ISBN: 979-8-6912-1830-9 Extrait de l'Internet: URL:https://etd.ohiolink.edu/acprod/odb_etd/ws/send_file/send?accession=ucin159584609 8921553&disposition=inline [extrait le 2024-09-26] * Chapitre 4; page 61 - page 72 * ----- | 1,3-9, 11-13 | |
| Y | CN 114 614 796 A (MICROELECTRONIC RES INSTITUTE OF CHINESE ACADEMY OF SCIENCES) 10 juin 2022 (2022-06-10) * figure 1 * ----- | 6,11 | |
| | | | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| Munich | 7 janvier 2026 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

..............................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 19 8248

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-01-2026

| Document brevet cité au rapport de recherche | Date de publication | Membre(s) de la famille de brevet(s) | Date de publication |
|---|---|---|---|
| US 2015236669 A1 | 20-08-2015 | US 2015236669 A1<br>US 2016322958 A1<br>US 2016322959 A1 | 20-08-2015<br>03-11-2016<br>03-11-2016 |
| CN 114614796 A | 10-06-2022 | AUCUN | |

EPO FORM P0460

Pour tout renseignement concernant cette annexe : voir Journal Officiel de l'Office européen des brevets, No.12/82